# FASCICULE DE BREVET EUROPEEN

(11) **EP 2 761 683 B1**
(45) Date de publication et mention de la délivrance du brevet: **16.09.2015**
(21) Numéro de dépôt: 12743502.2
(22) Date de dépôt: 12.07.2012
(51) Int. Cl.: H01L 51/40, H01L 51/56, H01L 51/00

(54) **PROCEDE DE STRUCTURATION D'UNE COUCHE ACTIVE ORGANIQUE DEPOSEE SUR UN SUBSTRAT**
VERFAHREN ZUR STRUKTURIERUNG EINER AUF EINEM SUBSTRAT ABGELAGERTEN ORGANISCHEN WIRKSTOFFSCHICHT
PROCESS FOR STRUCTURING AN ACTIVE ORGANIC LAYER DEPOSITED ON A SUBSTRATE

(30) Priorité: 30.09.2011 FR 1158776
(43) Date de publication de la demande: 06.08.2014
(73) Titulaire: Commissariat à l'Énergie Atomique et aux Énergies Alternatives, 75015 Paris (FR)
(72) Inventeur: HEITZMANN, Marie, F-38650 Sinard (FR); CHARLOT, Simon, F-38100 Grenoble (FR)
(74) Mandataire: Cabinet Laurent & Charras
(86) Numéro de dépôt international: PCT/FR2012/051649
(87) Numéro de publication internationale: WO 2013/045775

(56) Documents cités:
- WO-A2-2004/036663
- WO-A2-2011/004198
- US-A- 6 013 538

## Description

### DOMAINE TECHNIQUE

La présente invention a trait au domaine des composants électroniques dits organiques, et plus particulièrement aux problèmes liés à la localisation d'une couche active organique lors de la réalisation de composants électroniques ou similaires. L'invention concerne plus particulièrement un procédé de structuration d'une couche active organique déposée sur un substrat, et l'étape de gravure chimique de ladite couche active, lors de la fabrication d'une diode organique.

### ART ANTERIEUR

Dans le domaine de la microélectronique, c'est-à-dire des composants électroniques à l'échelle micrométrique, lesdits composants électroniques ont été initialement développés à partir de matériaux inorganiques tels que le silicium ou l'arséniure de galium (GaAs), notamment pour réaliser la couche dite active de ces composants, ces derniers étant constitués d'un empilement de telles couches inorganiques.

Ces composants électroniques inorganiques présentent l'inconvénient d'être coûteux à fabriquer et d'être rigides, et par conséquent d'être fragiles et inutilisables pour certaines applications.

Ainsi, les couches actives des composants électroniques sont désormais de plus en plus fréquemment réalisées à partir de matériaux organiques, tels que les polymères par exemple, qui présentent l'avantage d'être facilement fabriqués à grande échelle, d'avoir une bonne tenue mécanique et/ou thermique, de présenter une structure flexible et d'être facilement recyclables. Par ailleurs, les polymères étant solubles dans un solvant, ces derniers peuvent avantageusement être déposés en couche par des procédés de dépôt peu onéreux et faciles à mettre en oeuvre, tels que le dépôt à la tournette (mieux connu sous l'expression anglo-saxonne *« spin coating* »), le dépôt par jet d'encre ou le dépôt par sérigraphie notamment.

C'est la raison pour laquelle il est désormais courant de voir des écrans à base de diodes organiques dites OLED selon l'acronyme anglo-saxon « *Organic Light Emitting Diode* » ou à base de transistors organiques à couche mince dits OTFT, selon l'acronyme anglo-saxon *« Organic Thin-Film Transistor* ». Ces composants électroniques sont usuellement constitués d'un empilement de couches organiques et/ou inorganiques dans lequel la couche dite active est réalisée en un matériau organique.

Cependant, cet empilement de couches organiques et/ou inorganiques présente un certain nombre de difficultés, notamment lors de la réalisation de diodes organiques qui nécessite un dépôt très homogène d'une couche active organique, l'empilement des couches d'une diode organique étant usuellement le suivant : un substrat en verre, en plastique, en silicium, etc ..., une couche conductrice dite localisée obtenue dans de l'oxyde d'indium dopé à l'étain dit ITO selon l'acronyme anglo-saxon « *Indium tin oxide* », du métal, un polymère conducteur, etc..., une couche dite injectrice obtenue dans du poly(3,4-ethylenedioxythiophene) poly(styrenesulfonate) dit PEDOT:PSS par exemple, une couche active obtenue dans un mélange de semi-conducteur de type n et p appelé hétérojonction volumique, et une couche conductrice localisée obtenue dans du métal ou un polymère conducteur par exemple.

En effet, lors de la fabrication d'une diode organique, l'étape critique est le dépôt de la couche active organique. Cette couche organique doit être très homogène et sans aucun défaut susceptible d'occasionner une fuite électrique entre les deux couches conductrices de la diode. Cette couche organique active est usuellement déposée par un procédé de dépôt à la tournette qui permet d'obtenir des dépôts filmogènes. Toutefois, le dépôt à la tournette ne permet pas de structurer la couche active organique. Afin de structurer ladite couche active, après son dépôt sur le substrat, plusieurs techniques sont utilisées dont la gravure soustractive également appelée gravure directe, et le « lift-off ».

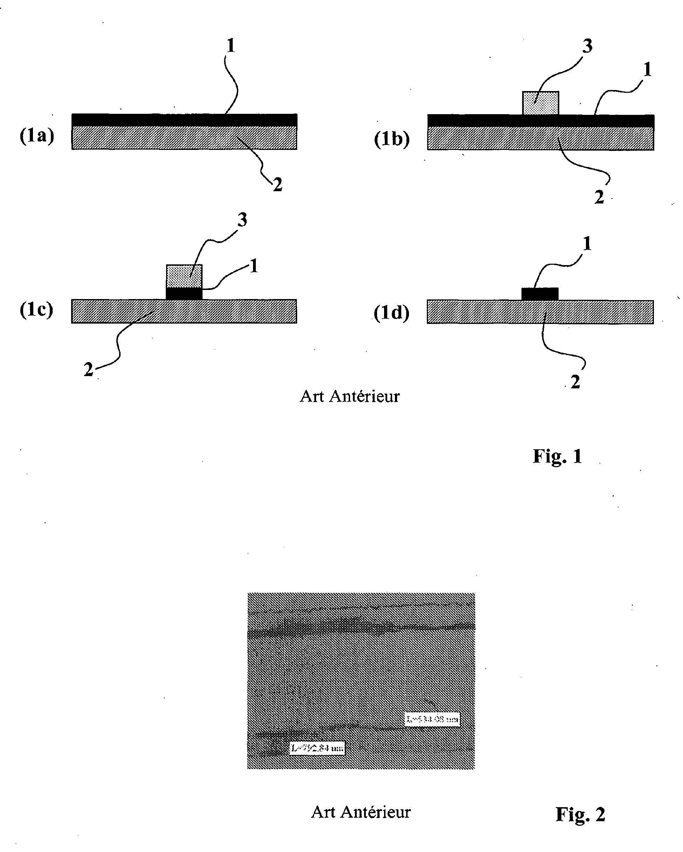

La gravure soustractive, illustrée par exemple sur la figure 1, consiste, après avoir déposé une couche active **1** sur un substrat **2** dans une étape 1a, à déposer lors d'une étape 1b un polymère **3,** et ce, de manière localisée sur la couche active **1** par tout moyen approprié tel que par jet d'encre ou par sérigraphie par exemple, ledit polymère **3** consistant par exemple dans un fluoropolymère commercialisé sous la marque CYTOP^{®}. Lors d'une étape 1c, les parties de la couche active **1** qui ne sont pas recouvertes par le polymère, sont ensuite gravées chimiquement par application d'un solvant du type xylène, chlorobenzène, tétraline, toluène, etc..., puis le polymère est « strippé », c'est-à-dire dissout, avec un solvant qui n'attaque pas la couche active **1,** tel que le perfluorotributylamine (FC43) par exemple.

Une telle gravure soustractive est notamment décrite dans le document WO 2011/004198.

La gravure soustractive présente l'inconvénient de détériorer la couche active, comme on peut le voir sur la figure 2, qui est une vue au microscope optique de la surface de la couche active après une gravure soustractive. En effet, l'action chimique du solvant de gravure provoque une « sur gravure » de la couche active sur les bords du motif.

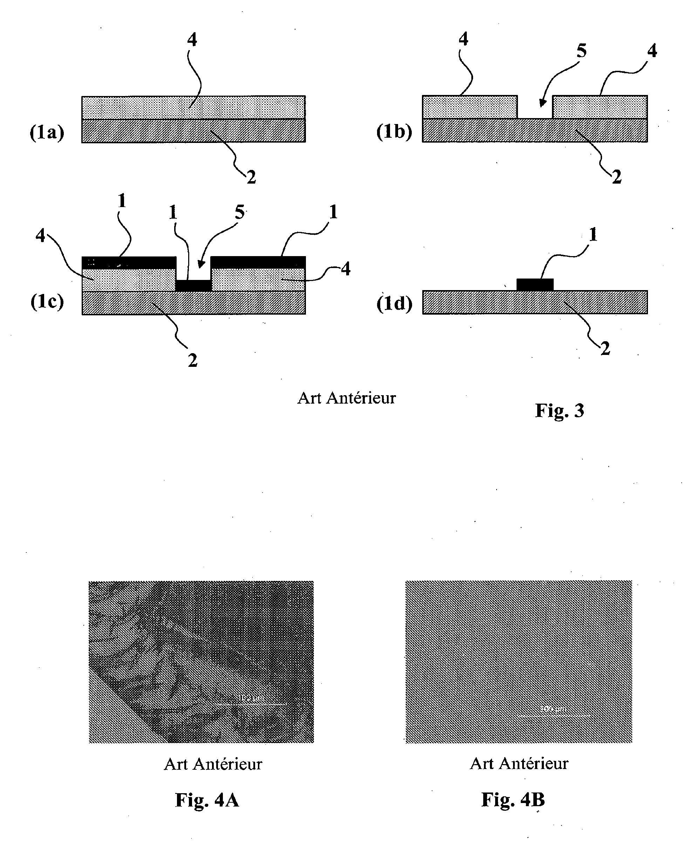

La seconde technique de structuration dite de « lift-off » consiste, en référence à la figure 3, à déposer une couche dite sacrificielle **4** de résine photosensible sur un substrat **2** lors d'une étape 1a, puis à structurer ladite couche sacrificielle **4** pour créer un motif **5** dans ladite couche sacrificielle **4** par gravure chimique par exemple, lors d'une étape 1b. Lors de l'étape 1c, une couche active organique **1** est déposée sur la couche sacrificielle **4** et au fond du motif **5**, puis, lors d'une dernière étape 1d, la couche sacrificielle **4** est dissoute dans un bain de solvant, généralement de l'acétone, pour ne laisser que le motif de la couche active 1 sur le substrat **2.**

Ce type de procédé de structuration dit de « Lift-off » est notamment décrit dans les documents US 2005/0048414 et US 2011/0012097.

Les documents WO 2004/036663 et US 6013538 décrivent également des procédés dit de "Lift-off".

Cette technique de « lift-off » présente également l'inconvénient de détériorer la couche active **1.** En effet, la couche active **1** est endommagée par l'action du bain d'acétone lors de la dissolution de la couche sacrifcielle, la durée du bain d'acétone étant d'environ 20 minutes. Ce bain d'acétone fragilise la couche active **1,** provoquant des bords de motifs mal définis et des « piqures », comme on peut le voir sur les figures 4A et respectivement 4B.

### EXPOSE DE L'INVENTION

L'un des buts de l'invention est donc de remédier à ces inconvénients en proposant un procédé de structuration d'une couche active organique déposée sur un substrat, de mise en oeuvre aisée et peu onéreuse et procurant des motifs de couche active sans défauts.

A cet effet, et conformément à l'invention, il est proposé un procédé de structuration d'une couche active organique déposée sur un substrat tel que décrit dans la revendication 1.

On comprend bien que, contrairement aux procédés de l'art antérieur, la couche protectrice en polymère déposée dans le motif de la couche sacrificielle en résine recouvre la couche active déposée dans ledit motif et la protège lors du retrait de la résine par projection d'un solvant. De plus, l'effet mécanique de la projection du solvant permet de réduire la durée de contact du solvant avec les différentes couches du composant, la durée de contact étant inférieure à 1 minute, contrairement aux procédés de l'art antérieur dans lesquels le solvant demeure en contact avec les couches pendant une durée d'environ 20 minutes, et d'éviter la redéposition de particules sur la couche active.

L'étape de création de motifs sur la résine photosensible comporte au moins les étapes suivantes :
- recuit de la couche sacrificielle en résine photosensible à une température comprise entre 100 et 130 °C pendant 1 à 5 minutes,
- exposition de la couche sacrificielle en résine photosensible recuite à la lumière à travers un masque comportant au moins motif, et
- révélation du motif par aspersion d'un révélateur sur ladite couche sacrificielle en résine photosensible.

La résine photosensible est constituée d'une résine dite négative, pour laquelle le rayonnement ultraviolet induit une polymérisation des zones exposées et/ou d'une résine dite positive, pour laquelle le rayonnement ultraviolet induit une transformation chimique des macromolécules de ladite résine, et/ou d'une résine dite inversible, qui présente la propriété de changer de polarité lors d'une étape de recuit dit d'inversion.

Par ailleurs, l'étape de retrait de la couche sacrificielle en résine photosensible consiste à projeter un solvant sur ladite couche sacrificielle en résine photosensible pendant une durée comprise entre 5 et 60 secondes, ledit solvant étant par exemple constitué par de l'acétone.

L'étape de dépôt d'une couche active organique consiste à déposer à la tournette un mélange de molécules ou de polymères organiques semi-conducteurs de type p et n.

Ledit mélange de molécules ou de polymères organiques semi-conducteurs de type p et n peut par exemple être constitué d'un mélange de poly(3-hexyl-thiophene) (P3HT) et de 1-(3-methoxy-carbonyl)propyl-1-phenyl-(6,6)C-61 (PCBM) dans de l'o-dichlorobenzène, ou d'un mélange de poly(3-octylthiophene-2,5-diyl)(P3OT) et de (6,6)-phenyl C₇₁ butyric acid ester (PC₇₁BM).

L'étape de dépôt d'une couche protectrice en polymère organique dans le motif de la couche sacrificielle en résine photosensible comporte au moins les étapes suivantes :
- dépôt par sérigraphie d'au moins un polymère alliphatique perfluoré thermoréticulable sur la couche active et dans le motif défini dans la couche sacrificielle en résine de photosensible, et
- recuit à une température comprise entre 40 et 80 °C pendant 2 à 10 minutes.

### DESCRIPTION SOMMAIRE DES FIGURES

D'autres avantages et caractéristiques ressortiront mieux de la description qui va suivre, d'une variante d'exécution du procédé de structuration d'une couche active déposée sur un substrat conforme à l'invention, donnée à titre d'exemple non limitatif, en référence aux dessins annexés pour lesquels :
- la figure 1 est une vue en coupe schématique des différentes étapes du procédé de structuration d'une couche active d'un composant électronique par gravure soustractive de l'art antérieur,
- la figure 2 est une vue au microscope optique des défauts de la surface de la couche active d'un composant électronique obtenu avec une structuration de la couche active par gravure soustractive de l'art antérieur,
- la figure 3 est une vue en coupe schématique des différentes étapes du procédé de structuration d'une couche active d'un composant électronique par un procédé de « Lift-off » de l'art antérieur,
- les figures 4A et 4B sont des vues au microscope optique des défauts de la surface de la couche active d'un composant électronique obtenu avec une structuration de la couche active par un procédé de « Lift-off » de l'art antérieur,
- la figure 5 est une vue en coupe schématique des différentes étapes du procédé de structuration d'une couche active d'un composant électronique conforme à l'invention,
- les figures 6A et 6B sont des vues au microscope optique de la surface sans défauts de la couche active d'un composant électronique obtenu selon le procédé de structuration de la couche active conforme à l'invention.

### DESCRIPTION DETAILLEE DE L'INVENTION

Par souci de clarté, dans la suite de l'invention, les mêmes éléments ont été désignés par les mêmes références aux différentes figures. De plus, les diverses vues en coupe ne sont pas nécessairement tracées à l'échelle.

Dans cet exemple particulier de réalisation, il va être décrit la gravure d'une couche active sur un substrat pour la réalisation de diodes organiques dites OLED. Toutefois, il est bien évident que le procédé selon l'invention peut être utilisé pour la réalisation de tout type de composants électroniques organiques, tels que des transistors du type OTFT par exemple, sans pour autant sortir du cadre de l'invention.

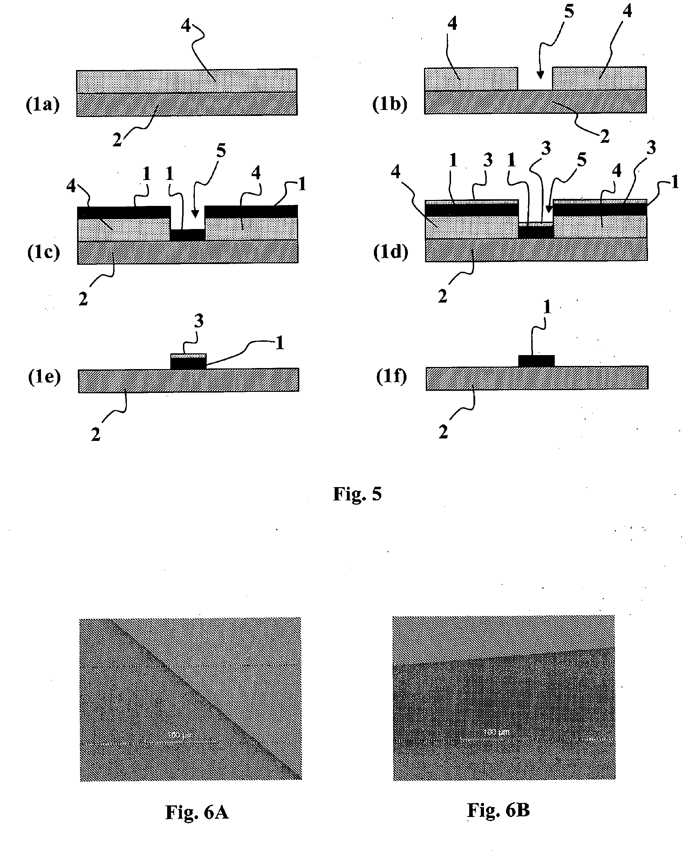

En référence à la figure 5, le procédé de structuration d'une couche active organique déposée sur un substrat selon l'invention comporte une première étape 1a de dépôt par photo-lithogravure d'une couche sacrificielle **4** de résine photosensible sur un substrat **2.d**

La résine photosensible **4** est par exemple, une résine dite positive, commercialisée sous la référence Microposit (marque déposée) S1818 (marque déposée) par la société Rohm and Haas Electronic Materials LLC. Elle présente une épaisseur comprise entre 1, et 4 micromètres.

Le substrat **2** est par exemple en verre, recouvert d'oxyde indium-étain dit ITO selon l'acronyme anglo-saxon *« Indium Tin Oxyde ».*

Le substrat **2** peut cependant être constitué de matière plastique, par exemple en polyéthylène naphtalate (PEN) ou en polyéthylène terephtalate (PET), et présenter sur sa face supérieure une couche mince de métal, tel que de l'or (Au), de l'argent (Ag), du paladium (Pd), de l'aluminium (Al), etc... d'épaisseur comprise entre 10 nanomètres et 500 nanomètres ou une couche polymère mince conductrice, telle qu'une couche de Poly(3,4-ethylenedioxythiophene) poly(styrenesulfonate) dit PEDOT:PSS, d'épaisseur comprise entre 50 et 2000 nanomètres ou une couche mince de conducteur inorganique, tel que de l'oxyde indium-étain (ITO) ou de l'oxyde gallium-zinc (GZO) par exemple, comprise entre 50 et 500 nanomètres.

Par ailleurs, la résine de photo lithogravure S1818 (marque déposée) utilisée dans cet exemple de réalisation est une résine dite positive, pour laquelle le rayonnement ultraviolet (UV) induit une transformation chimique des macromolécules de ladite résine, entraînant une solubilité accrue des zones exposées dans le révélateur. La résine de photo lithogravure peut donc être réalisée en toute résine positive, telle que la résine AZ® 9260 commercialisée par la société AZ electronic materials GmbH, ou la résine commercialisées sous la référence Microposit® SJR 5740® par la société Rohm and Haas Electronic Materials, par exemple.

La couche sacrificielle **4** peut également être réalisée en une résine photosensible dite négative, pour laquelle le rayonnement ultraviolet induit une polymérisation des zones exposées, conférant ainsi à ces zones une tenue particulière au solvant de révélation alors que les parties non insolées disparaissent sélectivement dans ledit solvant. Cette résine négative est par exemple commercialisée sous la référence SU-8 par la société MicroChem Corp..

La couche sacrificielle **4** peut enfin est constituée d'une résine dite inversible, qui présente la propriété de changer de polarité lors d'une étape de recuit dit d'inversion. Une telle résine inversible est par exemple commercialisée sous la référence AZ® 5214 par la société AZ electronic materials GmbH, ou la résine commercialisée sous la référence T109XR®.

Dans une étape 1b, on crée au moins un motif **5,** également appelé « pixel de diode ». A cet effet, la couche sacrificielle **4** en résine photosensible est recuite à une température comprise entre 100 et 130 °C pendant 1 à 5 minutes, et de préférence à une température de 115 °C pendant 3 minutes. Puis la résine photosensible est insolée, c'est-à-dire exposée aux ultraviolets (UV), à travers un masque comportant au moins ledit motif, le masque n'étant pas représenté sur la figure 5. Finalement, le motif **5** est révélé en appliquant un révélateur sur la couche sacrificielle **4** en résine photosensible pendant environ 45 secondes, ledit révélateur étant par exemple commercialisé sous la référence Microposit® MF319® par la société Rohm and Haas Electronic Materials.

Après cet étape de création d'un motif **5** dans la couche sacrificielle **4** en résine photosensible, le procédé selon l'invention comporte une étape 1c de dépôt d'une couche active organique **1** sur la couche sacrificielle **4** et dans ledit motif **5**.

Cette étape de dépôt d'une couche active organique **1** consiste à déposer une épaisseur comprise entre 10 et 300 nanomètres d'un mélange de molécules ou de polymères organiques semi-conducteurs de type p et n.

Ledit mélange de molécules ou de polymères organiques semi-conducteurs de type p et n est par exemple constitué d'un mélange de poly(3-hexyl-thiophene) (P3HT) et de 1-(3-methoxy-carbonyl)propyl-1-phenyl-(6,6)C-61 (PCBM) dans de l'o-dichlorobenzène. Il peut également être constitué d'un mélange de poly(3-octylthiophene-2,5-diyl)(P3OT) et de (6,6)-phenyl C₇₁ butyric acid ester (PC₇₁BM). Il peut en outre être constitué de tout autre mélange approprié bien connu de l'homme du métier.

La couche active organique **1** peut être déposée par un dépôt à la tournette ou par tout autre procédé procurant un dépôt homogène approprié tel que, par exemple, un dépôt par étalement, un dépôt par sérigraphie ou un dépôt par impression.

Ensuite, dans une étape 1d, on dépose une couche dite protectrice **3** réalisée en polymère organique sur la couche active **1** et dans le motif **5** de la couche sacrificielle **4** en résine.

Cette étape de dépôt d'une couche protectrice **3** consiste à déposer par sérigraphie sur une épaisseur comprise entre 100 et 5000 nanomètres au moins un polymère alliphatique perfluoré thermoréticulable, tel qu'un polymère perfluoré commercialisé sous la référence Cytop^{®}. L'ensemble obtenu fait alors l'objet d'un recuit pendant 2 à 10 minutes sous une température comprise entre 40 et 80 °C, et de pendant 6 minutes sous une température de 60 °C.

Dans une étape 1e, on retire la couche sacrificielle **4** en résine photosensible par projection d'un solvant sur ladite résine. Cette étape de retrait consiste à pulvériser un jet de solvant, tel que de l'acétone par exemple, par tout moyen approprié sur la couche sacrificielle **4** pendant une durée comprise entre 5 et 60 secondes, et de préférence pendant une durée comprise entre 10 et 30 secondes. Cette étape de retrait de la couche sacrificielle **4** induit le retrait simultané de la couche active **1** et de la couche protectrice **3,** à l'exception de la couche active **1** et de la couche protectrice **3** initialement déposées dans le motif **5.**

On peut observer que la couche protectrice **3** déposé dans le **motif 5** de la couche sacrificielle **4** recouvre la couche active **1** déposée dans ledit motif **5** et la protège lors du retrait de la couche sacrificielle par projection d'un solvant, évitant ainsi toute altération de la surface de ladite couche active. De plus, l'effet mécanique de la projection du solvant permet de réduire la durée de contact du solvant avec les différentes couches du composant, la durée de contact étant de l'ordre de 20 secondes, et par conséquent les risques de détérioration de la couche active 1. On s'affranchit également du redépôt de particules sur la couche active.

Dans une dernière étape 1f, on retire la couche protectrice **3** par dissolution dudit polymère qui la constitue dans un solvant, tel que du perfluorotributylamine (FC43). On peut noter que, lors du retrait de la couche protectrice **3,** le solvant n'est au contact que des parois latérales de couche active **1,** évitant ainsi d'altérer la face supérieure de la couche active **1.**

De cette manière, comme on peut le constater sur les figures 6A et 6B qui sont des vues au microscope optique de la surface de la couche active 1, et plus particulièrement l'arrête entre la face supérieure et une paroi latérale de la couche active 1 d'un composant électronique obtenu selon le procédé de structuration de la couche active conforme à l'invention, la face supérieure de ladite couche active 1 et les arrêtes de cette dernière ainsi obtenue ne comportent aucun défaut.

## Revendications

1. Procédé de structuration d'une couche active organique (1) déposée sur un substrat (2), ***caractérisé* en ce qu'**il consiste :
- à déposer une couche sacrificielle (4) sur le substrat (2) par photo-lithogravure, ladite couche sacrificielle étant réalisée en au moins une résine photosensible,
- à créer au moins une ouverture au sein de la couche sacrificielle (4) définissant un motif (5),
- à déposer une couche active organique (1) sur la couche sacrificielle (4) et dans le motif (5),
- à déposer une couche protectrice (3) réalisée en polymère organique sur la couche active (1) et dans le motif (5) de ladite couche sacrificielle (4),
- à retirer la couche sacrificielle (4) par projection d'un solvant sur la résine constitutive de ladite couche, induisant le retrait simultané de la couche active organique (1) et de la couche protectrice (3), à l'exception de la couche active organique (1) et de la couche protectrice (3) initialement déposées dans le motif (5) ; et ensuite
- à retirer la couche protectrice (3) par dissolution du polymère qui la constitue dans un solvant.

2. Procédé de structuration d'une couche active organique selon la revendication 1, ***caractérisé* en ce que** l'étape de création de motifs (5) dans la couche sacrificielle (4) comporte au moins les étapes suivantes :
- recuit de la couche sacrificielle (4) à une température comprise entre 100 et 130°C pendant 1 à 5 minutes,
- exposition de la couche sacrificielle (4) ainsi recuite à la lumière à travers un masque comportant au moins ledit motif,
- révélation du motif (5) par aspersion d'un révélateur sur ladite couche sacrificielle (4).

3. Procédé de structuration d'une couche active organique selon l'une des revendications 1 et 2, ***caractérisé* en ce que** la résine photosensible constitutive de la couche sacrificielle (4) est constituée d'une résine dite négative, pour laquelle le rayonnement ultraviolet induit une polymérisation des zones exposées.

4. Procédé de structuration d'une couche active organique selon l'une des revendications 1 et 2, ***caractérisé* en ce que** la résine photosensible constitutive de la couche sacrificielle (4) est constituée d'une résine dite positive, pour laquelle le rayonnement ultraviolet induit une transformation chimique des macromolécules de ladite résine.

5. Procédé de structuration d'une couche active organique selon l'une des revendications 1 et 2, ***caractérisé* en ce que** la résine photosensible constitutive de la couche sacrificielle (4) est constituée d'une résine dite inversible, qui présente la propriété de changer de polarité lors d'une étape de recuit dit d'inversion.

6. Procédé de structuration d'une couche active organique selon l'une quelconque des revendications 1 à 5, ***caractérisé* en ce que** l'étape de retrait de la couche sacrificielle (4) consiste à projeter un solvant sur ladite couche sacrificielle (4) pendant une durée comprise entre 5 et 60 secondes.

7. Procédé de structuration d'une couche active organique selon la revendication 6, ***caractérisé* en ce que** le solvant est de l'acétone.

8. Procédé de structuration d'une couche active organique selon l'une quelconque des revendications 1 à 7, ***caractérisé* en ce que** l'étape de dépôt d'une couche active organique (1) consiste à déposer à la tournette un mélange de molécules ou de polymères organiques semi-conducteurs de type p et n.

9. Procédé de structuration d'une couche active organique selon la revendication 8, ***caractérisé* en ce que** le mélange de molécules ou de polymères organiques semi-conducteurs de type p et n consiste dans un mélange de poly(3-hexyl-thiophene) (P3HT) et de 1-(3-methoxy-carbonyl)propyl-1-phenyl-(6,6)C-61 (PCBM) dans de l'o-dichlorobenzène.

10. Procédé de structuration d'une couche active organique selon la revendication 8, ***caractérisé* en ce que** le mélange de molécules ou de polymères organiques semi-conducteurs de type p et n consiste dans un mélange de poly(3-octylthiophene-2,5-diyl)(P3OT) et de (6,6)-phenyl C₇₁ butyric acid ester (PC₇₁BM).

11. Procédé de structuration d'une couche active organique selon l'une quelconque des revendications 1 à 10, ***caractérisé* en ce que** l'étape de dépôt d'une couche protectrice (3) en polymère organique sur la couche active (1) et dans le motif (5) de la couche sacrificielle (4) consiste :
- à déposer par sérigraphie au moins un polymère alliphatique perfluoré thermoréticulable sur la couche active (1) et dans le motif (5) défini dans la couche sacrificielle (4),
- à recuire à une température comprise entre 40 et 80°C pendant 2 à 10 minutes.

## Patentansprüche

1. Verfahren zum Strukturieren einer aktiven organischen Schicht (1), die auf einem Substrat (2) abgeschieden ist, **dadurch gekennzeichnet, dass** es darin besteht:
- eine Opferschicht (4) auf dem Substrat (2) durch Fotolithografie abzuscheiden, wobei die Opferschicht aus mindestens einem lichtempfindlichen Harz hergestellt ist,
- mindestens eine ein Muster (5) definierende Öffnung in der Opferschicht (4) zu schaffen,
- eine aktive organische Schicht (1) auf der Opferschicht (4) und im Muster (5) abzuscheiden,
- eine aus organischem Polymer hergestellte Schutzschicht (3) auf der aktiven Schicht (1) und im Muster (5) der Opferschicht (4) abzuscheiden,
- die Opferschicht (4) durch Aufspritzen eines Lösungsmittels auf das die Schicht bildende Harz abzuziehen, wodurch das gleichzeitige Abziehen der aktiven organischen Schicht (1) und der Schutzschicht (3) mit Ausnahme der aktiven organischen Schicht (1) und der Schutzschicht (3), die anfänglich im Muster (5) abgeschieden wurden, bewirkt wird; und dann
- die Schutzschicht (3) durch Auflösen des sie bildenden Polymers in einem Lösungsmittel abzuziehen.

2. Verfahren zum Strukturieren einer aktiven organischen Schicht nach Anspruch 1, **dadurch gekennzeichnet, dass** der Schritt zur Erzeugung von Mustern (5) in der Opferschicht (4) mindestens die folgenden Schritte umfasst:
- Ausheizen der Opferschicht (4) bei einer Temperatur zwischen 100 und 130°C während 1 bis 5 Minuten,
- Lichtbeaufschlagen der so ausgeheizten Opferschicht (4) durch eine Maske, die zumindest das Muster trägt,
- Enthüllen des Musters (5) durch Aufsprühen einer Entwicklungssubstanz auf die Opferschicht (4).

3. Verfahren zum Strukturieren einer aktiven organischen Schicht nach einem der Ansprüche 1 und 2, **dadurch gekennzeichnet, dass** das die Opferschicht (4) bildende lichtempfindliche Harz aus einem sogenannten Negativharz besteht, bei dem Ultraviolettstrahlung eine Polymerisation der exponierten Bereiche bewirkt.

4. Verfahren zum Strukturieren einer aktiven organischen Schicht nach einem der Ansprüche 1 und 2, **dadurch gekennzeichnet, dass** das die Opferschicht (4) bildende lichtempfindliche Harz aus einem sogenannten Positivharz besteht, bei dem Ultraviolettstrahlung eine chemische Umwandlung der Makromoleküle des Harzes bewirkt.

5. Verfahren zum Strukturieren einer aktiven organischen Schicht nach einem der Ansprüche 1 und 2, **dadurch gekennzeichnet, dass** das die Opferschicht (4) bildende lichtempfindliche Harz aus einem sogenannten invertierbaren Harz besteht, das die Eigenschaft aufweist, die Polarität bei einem sogenannten Inversionsausheizschritt zu wechseln.

6. Verfahren zum Strukturieren einer aktiven organischen Schicht nach einem der Ansprüche 1 bis 5, **dadurch gekennzeichnet, dass** der Schritt des Abziehens der Opferschicht (4) darin besteht, ein Lösungsmittel während eines Zeitraums zwischen 5 und 60 Sekunden auf die Opferschicht (4) aufzuspritzen.

7. Verfahren zum Strukturieren einer aktiven organischen Schicht nach Anspruch 6, **dadurch gekennzeichnet, dass** das Lösungsmittel Aceton ist.

8. Verfahren zum Strukturieren einer aktiven organischen Schicht nach einem der Ansprüche 1 bis 7, **dadurch gekennzeichnet, dass** der Schritt des Abscheidens einer aktiven organischen Schicht (1) darin besteht, ein Gemisch aus organischen Halbleitermolekülen oder -polymeren des p- und n-Typs durch Schleuderbeschichtung abzuscheiden.

9. Verfahren zum Strukturieren einer aktiven organischen Schicht nach Anspruch 8, **dadurch gekennzeichnet, dass** das Gemisch aus organischen Halbleitermolekülen oder -polymeren des p- und n-Typs aus einem Gemisch aus Poly(3-hexyl-tiophen) (P3HT) und 1-(3-Methoxy-carbonyl)propyl-1-phenyl-(6,6)C-61 (PCBM) in o-Dichlorbenzol besteht.

10. Verfahren zum Strukturieren einer aktiven organischen Schicht nach Anspruch 8, **dadurch gekennzeichnet, dass** das Gemisch aus organischen Halbleitermolekülen oder -polymeren des p- und n-Typs aus einem Gemisch aus Poly(3-Octylthiophen-2,5-diyl) (P3OT) und (6,6)-Phenyl-C₇₁-Buttersäureester (PC₇₁BM) besteht.

11. Verfahren zum Strukturieren einer aktiven organischen Schicht nach einem der Ansprüche 1 bis 10, **dadurch gekennzeichnet, dass** der Schritt des Abscheidens einer Schutzschicht (3) aus organischem Polymer auf die aktive Schicht (1) und im Muster (5) der Opferschicht (4) darin besteht:
- durch Siebdruck mindestens ein wärmevernetzbares, perfluoriertes, aliphatisches Polymer auf der aktiven Schicht (1) und in dem in der Opferschicht (4) definierten Muster (5) abzuscheiden,
- bei einer Temperatur zwischen 40 und 80° während 2 bis 10 Minuten auszuheizen.

## Claims

1. A method of structuring an active organic layer (1) deposited on a substrate (2), wherein it comprises:
- depositing a sacrificial layer (4) on the substrate (2) by photolithography, said sacrificial layer being made of at least one photosensitive resin,
- creating at least one opening inside of the sacrificial layer (4) defining a pattern (5),
- depositing an active organic layer (1) on the sacrificial layer (4) and in the pattern (5),
- depositing a protective layer (3) made of organic polymer on the active layer (1) and in the pattern (5) of said sacrificial layer (4),
- removing the sacrificial layer (4) by projection of a solvent on the resin forming said layer, inducing the simultaneous removal of the active organic layer (1) and of the protective layer (3), except for said active organic layer (1) and protective layer (3) initially deposited in pattern (5) ; and then
- removing the protective layer (3) by dissolving the polymer forming it in a solvent.

2. The method of structuring an active organic layer of claim 1, wherein the step of creating patterns (5) in the sacrificial layer (4) comprises at least the steps of:
- annealing the sacrificial layer (4) at a temperature in the range from 100 to 130°C for from 1 to 5 minutes,
- exposing the sacrificial layer (4) thus annealed to light through a mask comprising at least said pattern,
- developing the pattern (5) by sprinkling a developer on said sacrificial layer (4).

3. The method of structuring an active organic layer of any of claims 1 and 2, wherein the photosensitive resin forming the sacrificial layer (4) is made of a so-called negative resin, for which ultraviolet radiation induces a polymerizing of the exposed areas.

4. The method of structuring an active organic layer of any of claims 1 and 2, wherein the photosensitive resin forming the sacrificial layer (4) is made of a so-called positive resin, for which ultraviolet radiation induces a chemical transformation of the macromolecules of said resin.

5. The method of structuring an active organic layer of any of claims 1 and 2, wherein the photosensitive resin forming the sacrificial layer (4) is made of a so-called reversible resin, which has the property of changing polarity in a so-called reversion anneal step.

6. The method of structuring an active organic layer of any of claims 1 to 5, wherein the step of removing the sacrificial layer (4) comprises projecting a solvent on said sacrificial layer (4) for a duration in the range from 5 to 60 seconds.

7. The method of structuring an active organic layer of claim 6, wherein the solvent is acetone.

8. The method of structuring an active organic layer of any of claims 1 to 7, wherein the step of depositing an active organic layer (1) comprises depositing by spin coating a mixture of organic p- and n-type semiconductor molecules or polymers.

9. The method of structuring an active organic layer of claim 8, wherein the mixture of organic p- and n-type semiconductor molecules or polymers is a mixture of poly(3-hexyl-thiophene) (P3HT) and of 1-(3-methoxy-carbonyl)propyl-1-phenyl-(6,6)C-61 (PCBM) in o-dichlorobenzene.

10. The method of structuring an active organic layer of claim 8, wherein the mixture of organic p- and n-type semiconductor molecules or polymers is a mixture of poly(3-octylthiophene2,5-diyl)(P3OT) and of (6,6)-phenyl C₇₁ butyric acid ester (PC₇₁BM).

11. The method of structuring an active organic layer of any of claims 1 to 10, wherein the step of depositing a protective organic polymer layer (3) on the active layer (1) and in the pattern (5) of the sacrificial layer (4) comprises:
- depositing by silk-screening at least one thermocrosslinkable perfluorinated aliphatic polymer on the active layer (1) and in the pattern (5) defined in the sacrificial layer (4),
- annealing at a temperature in the range from 40 to 80°C for from 2 to 10 minutes.
